# EUROPEAN PATENT APPLICATION

(11) **EP 4 807 384 A1**
(43) Date of publication of application: **16.09.2026**
(21) Application number: 25163198.2
(22) Date of filing: 12.03.2025
(51) Int. Cl.: G01R 33/343, G01R 33/26

(54) **MICROWAVE DEVICE AND METHOD**

(71) Applicant: Nederlandse Organisatie voor Toegepast-Natuurwetenschappelijk Onderzoek TNO, 2595 DA 's-Gravenhage (NL); Technische Universiteit Delft, 2628 CN Delft (NL)
(72) Inventor: The designation of the inventor has not yet been filed
(74) Representative: Nederlandsch Octrooibureau

(57) **Abstract**

Microwave device comprising a dielectric substrate comprising dielectric material and a conductive via extending through the dielectric substrate between a top surface of the dielectric substrate and a bottom surface of the dielectric substrate, a ground plate formed on the bottom surface of the dielectric substrate, and an antenna element formed on the top surface of the dielectric substrate, wherein the antenna element comprises a first region arranged to receive an input signal and a second region overlapping the conductive via such that is electrically connected to the ground plate through the conductive via.

## Description

### FIELD OF THE INVENTION

The invention relates to a microwave device and a corresponding method.

### BACKGROUND OF THE INVENTION

Wide-field magnetometers are a new technology to spatially map the (vector) magnetic field of a sample of interest. This can be used for a variety of applications, ranging from material characterization to micron-scale nuclear magnetic resonance (NMR). The sample of interest is placed below a diamond with a thin layer of nitrogen-vacancy (NV) centers. These NV centers are sensitive to the magnetic field of the sample below. Using (green) laser excitation combined with the application of microwaves, the magnetic field that the NV centers sense can be reconstructed. Due to four different NV-center orientations in the diamond lattice, the vector of the magnetic field can be reconstructed.

To construct nitrogen-vacancy-based quantum sensors, one of the essential ingredients is the application of microwave fields, typically around 2-4 GHz. Broadly speaking, there are two approaches for that. First, one can pattern a metal (usually gold) on the diamond to create a stripline or coplanar waveguide close to the NV centers. Second, one can fabricate an external microwave component (for example on a Printed Circuit Board (PCB)) and bring the diamond in close contact with said microwave component.

"Design of a High-Bandwidth Uniform Radiation Antenna for Wide-Field Imaging with Ensemble NV Color Centers in Diamond" by Zhiming Li, Micromachines issue 7, volume 13, discloses the design of a high-bandwidth antenna for NV-based wide-field imaging that uses an Omega-loop in which the diamond is placed between two striplines that transmit the applied microwaves.

"Optimized Planar Microwave Antenna for Nitrogen Vacancy Center Based Sensing Applications" by Oliver Roman Opaluch in Nanomaterials 2021 issue 8, volume 11, also discloses an antenna for microwave driving of NV centers which is a resonator thereby having a limited bandwidth of a few 100 Megahertz (MHz).

"Integrated coplanar waveguide coil on diamond for enhanced homogeneous broadband NV magnetometry", by Hossein Babashah in Open Research Europe, discloses an integrated coplanar waveguide wherein the antenna is integrated by patterning gold on the diamond.

### SUMMARY OF THE INVENTION

According to a first aspect of the invention, a microwave device is provided, the microwave device comprising a dielectric substrate comprising dielectric material and a conductive via extending through the dielectric substrate between a top surface of the dielectric substrate and a bottom surface of the dielectric surface, a ground plate formed on the bottom surface of the dielectric substrate, and an antenna element formed on the top surface of the dielectric substrate, wherein the antenna element comprises a first region arranged to receive an input signal and a second region overlapping the conductive via such that it is electrically connected to the ground plate through the conductive via. The conductive via behaves as a short circuit, raising the current that goes through the loop antenna. Due to the non-dispersive behavior of the via in a frequency of operation, a wideband short-circuit is achieved and in turn a uniform frequency response of the generated electromagnetic field.

The dielectric substrate may be made of any suitable dielectric material or of a combination of dielectric materials. The dielectric substrate may be, for example, a rigid or flexible printed circuit board or other dielectric substrate. The dielectric substrate may include multiple stacked dielectric layers (e.g., multiple layers of printed circuit board substrate such as multiple layers of fiberglass-filled epoxy) or may include a single dielectric layer. The dielectric substrate may include any desired dielectric materials such as glass, epoxy, plastic, ceramic, foam, or any kind of resin or any other materials.

The antenna element may be mounted on the top surface of the dielectric substrate and lie on an antenna plane that is separated from and parallel to a ground plane containing the ground plate. The antenna element and the ground plate may therefore lie in separate parallel planes that are separated by a distance equal to the thickness of the dielectric substrate. The antenna element and the ground plate may be formed from conductive traces patterned respectively on the top and bottom surfaces of the dielectric substrate such as metal foil, stamped sheet metal, or any other desired conductive structures.

The conductive via may comprise a cylindrical hole traversing through the dielectric substrate. The cylindrical hole may be perpendicular to the antenna plane containing the antenna element and to the ground plane containing the ground plate. The walls of the hole may be lined with a conductive material.

The ground plate may be formed from a conductive material. The antenna element may also be formed out of a conductive material. The ground plate may be formed from the same conductive material as the antenna element and the conductive via. However, the ground plate may be formed from a different conductive material than the antenna element and/or the conductive via. Conductive materials that may be used to form the ground plate and/or the antenna element and/or the conductive via are metals such as copper, and/or any other suitable conductive material.

The antenna element may be a microstrip plated on the top surface of the dielectric substrate by any known technique. For instance, the antenna element may be printed on the dielectric substrate using lithographic techniques or any other known technique. The microwave device may be fabricated by etching the microstrip antenna element pattern in metal trace bonded to the dielectric substrate. The antenna element may be formed by first applying a metal coating over the whole top surface of the dielectric substrate and removing later parts of the metal coating such that the antenna element is formed. For instance, the antenna element may be formed by an etching process wherein acid, or laser is used to remove parts of the metal coating. The ground plate may be formed using similar techniques.

An ohmic resistance between the part of the antenna element connected to the conductive via and the ground plate may be substantially zero. The ohmic resistance may be the resistance of the conductive via that connects them.

The antenna element may comprise an open loop shape. In this way, a large magnetic field is generated inside the open loop shape. The second region may comprise an oval or drop shape. However, the second region may comprise any other suitable shape.

The antenna element may comprise a feeding line connected at the first region and configured to receive the input signal. The feeding line may comprise an elongated shape and may be matched to the open loop shape part of the antenna element by a simple tapered transition.

The open loop shape may be chosen from the group consisting of oval, rectangular, triangular, hexagonal and non-regular geometric shapes.

The open loop shape may comprise a size between 10 micrometers and 10 millimeters, and more preferably between 100 micrometers and 5000 micrometers.

The dielectric substrate may comprise an aperture extending from the top surface to the bottom surface such that light can pass through the substrate.

The aperture may be surrounded by the open loop shape of the antenna element.

The microwave device may further comprise one or more bottom extra layers of dielectric material formed on the ground plate such that the microwave device comprises, from top to bottom, the antenna element, the dielectric substrate, the ground plate and the one or more bottom layers of dielectric material.

The microwave device may also comprise one or more top extra layers of dielectric material formed on the antenna element such that the microwave device comprises, from top to bottom, the one or more top extra layers of dielectric material, the antenna element, the dielectric substrate, and the ground plate.

According to a second aspect of the invention, a wide-field magnetometer for spatially mapping a magnetic field of a sample is provided, the wide-field magnetometer comprising a diamond substrate comprising a plurality of nitrogen vacancy centers sensitive to the magnetic field of the sample, the microwave device described above, and a light source configured to excite the plurality of nitrogen vacancy centers, wherein the microwave antenna is configured to generate a first signal for the nitrogen vacancy centers such that an effect of the magnetic field of the sample on the plurality of vacancy centers can be measured to reconstruct the magnetic field.

According to another aspect of the invention, a method of manufacturing a microwave device is provided, the method comprising:
- Providing a dielectric substrate comprising dielectric material;
- Forming a conductive via that extends through the dielectric substrate from a top surface of the dielectric substrate to a bottom surface of the substrate, wherein the bottom surface is located opposite to the top surface;
- Forming an antenna on the top surface of the substrate; and
- Forming a ground plate structure on the bottom surface of the dielectric substrate.

### BRIEF DESCRIPTION OF THE DRAWINGS

The invention will be described further with respect to embodiments shown in the drawings.

Figs. 1, 2B and 3 show schematically an upper view of a microwave device according to an embodiment of the disclosure.
Figs. 2A and 4 show schematically lower views of the microwave device of Fig. 1.
Fig. 5 shows schematically a side view of the microwave device of Fig. 1.
Figs. 6 and 7 show further details of the microwave device of Fig. 1.
Fig. 8 shows a flowchart of a method of manufacturing a microwave device according to an embodiment of the disclosure.

### DESCRIPTION

The following is a description of certain embodiments of the invention, given by way of example only and with reference to the figures. It is also to be understood that the terminology used herein is for the purpose of describing particular aspects only and is not intended to be limiting.

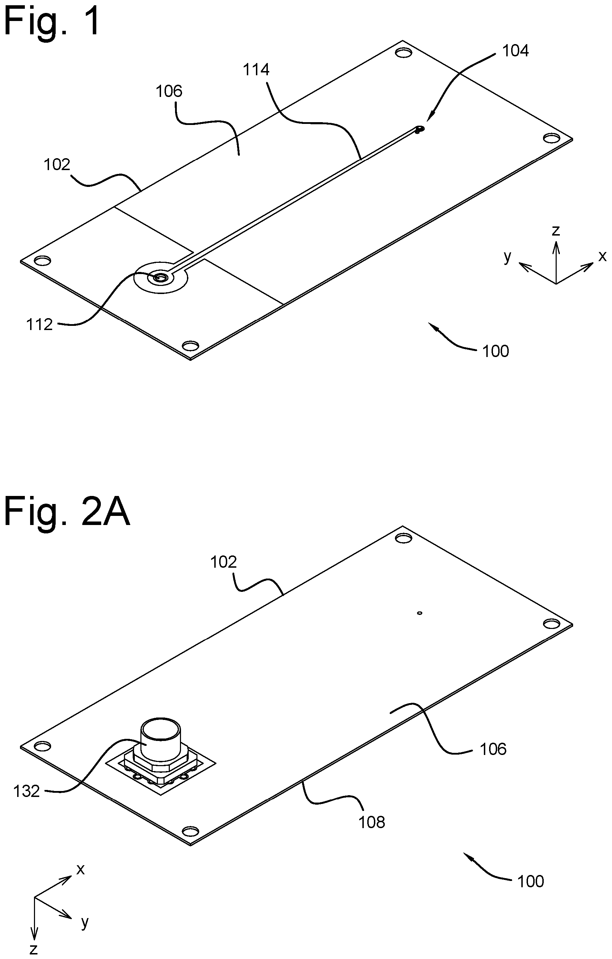

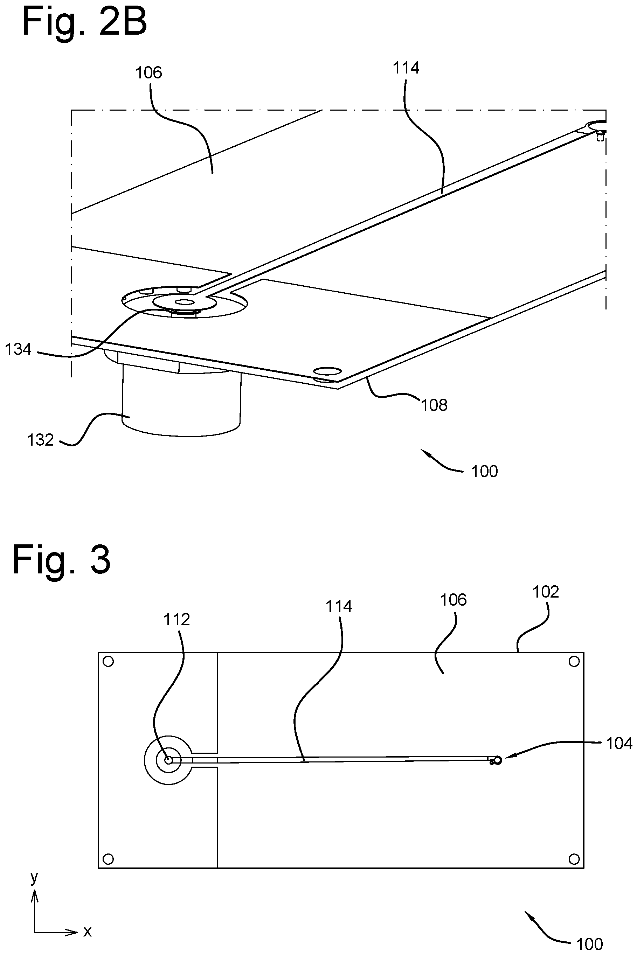

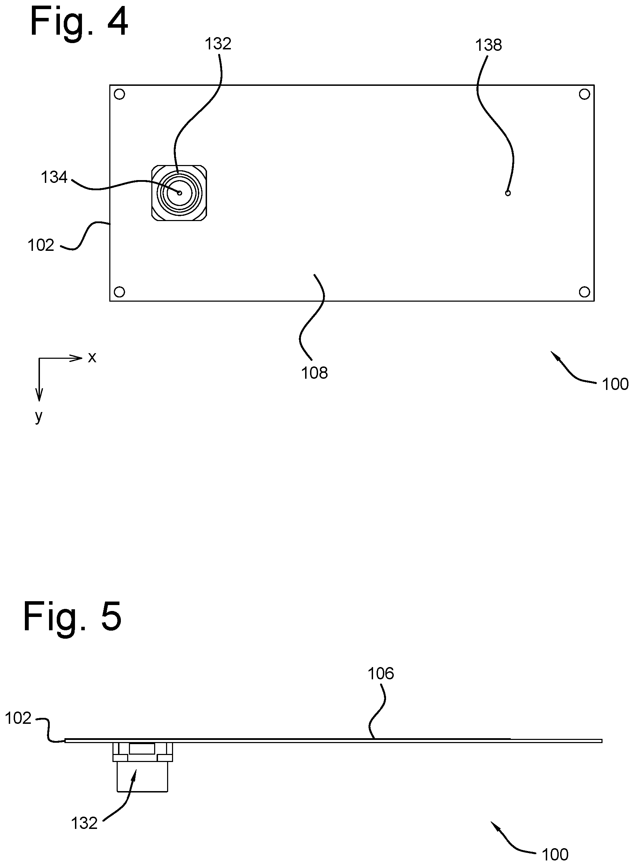

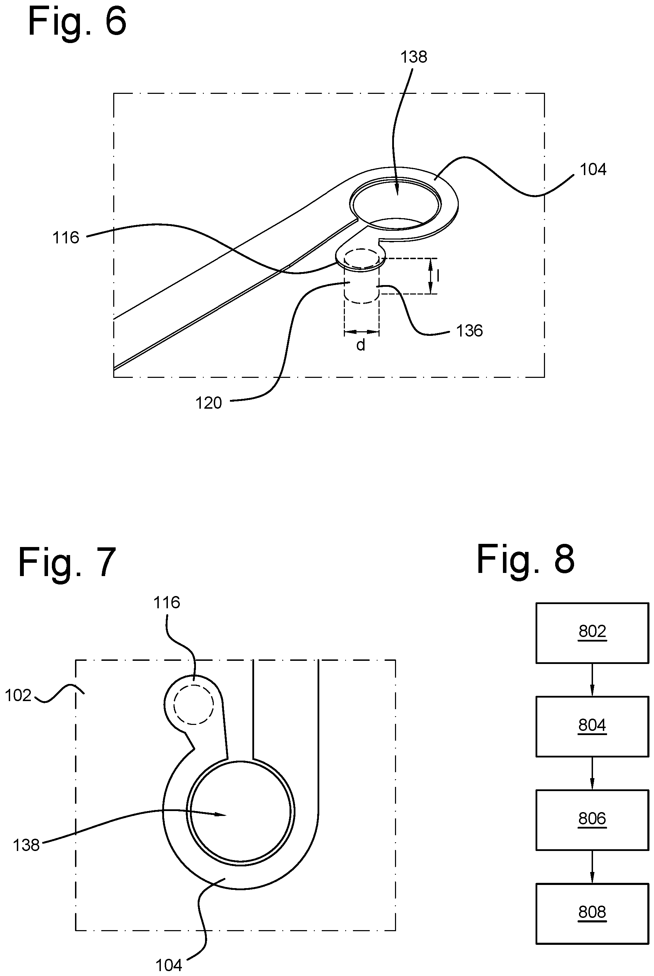

Figs. 1, 2B and 3 show an upper view of a microwave device according to an embodiment of the disclosure, figs. 2A and 4 show lower views and fig. 5 shows a side view of the same microwave device. In figs. 6 and 7 further details of the microwave device of figs. 1-5 can be appreciated.

The microwave antenna 100 shown in figs. 1-5 comprises a dielectric substrate 102 made of dielectric material. The dielectric substrate 102 may be made of ceramic-filled composites, hydrocarbon ceramic, woven glass reinforced hydrocarbon/ceramic and/or any other suitable material or combinations of materials and may have a width between 1 millimeters (mm) and 500 mm, more preferably between 5 mm and 100 mm, a length between 1 mm and 500 mm, more preferably between 5 mm and 100 mm, and a thickness between 50 micrometers (um) and 5000 um, more preferably between 100 um - 3000 um, wherein the length extends on a direction parallel to the X axis, the width on a direction parallel to the Y axis and the thickness on a direction parallel to the Z axis as shown in figs. 1-2.

The microwave device 100 comprises further, as shown in figs. 1 and 3, an antenna element 104 that is formed on a top surface 106 of the dielectric substrate 102, and also comprises, as shown in fig. 4, a ground plate 108 formed on a bottom surface of the dielectric substrate 102, wherein the bottom surface is located opposite to the top surface 106. The antenna element 104 also comprises a feeding line 114 that may have a thickness between 10 nm and 50 um, a width 10 um - 3 mm and a length 1 mm - 100 mm, wherein the length of the feeding line extends on a direction parallel to the X axis, the width on a direction parallel to the Y axis and the thickness on a direction parallel to the Z axis as shown in figs. 1-2A. However, the feeding line may have any other dimensions and/or configuration.

The antenna element 104 may be made of a metal material such as, for instance, copper. The antenna element 104 may be coated with nickel and/or gold. The antenna element 104 may be made of any other suitable conductive material.

As said and as shown in figs. 1-6, the microwave device 100 comprises the ground plate 108 and a metallic structure of a predetermined shape, which forms the antenna element 104, disposed parallel to the ground plate. The dielectric substrate 102 separates the antenna element from the ground plate and the conductive via 136 connects the second region of the antenna element 104 to the ground plate 108.

As shown in figs. 1 and 3, the antenna element 104 comprises a feeding line 114 configured to receive an input signal. The antenna element 104 further comprises a second region 116 electrically connected to the ground plate 108 by the conductive via 136 that extends from the top surface to the bottom surface through the dielectric substrate 102. Specifically, the conductive via 136 is connected at one end to the ground plate 108 and at the other end to the second region 116 of the antenna element 104. In this way, the ohmic resistance between the second region 116 of the antenna element 104 and the ground plate 108 may be substantially zero.

As shown in fig. 6, the conductive via 136 comprises a hollow cylinder or cylindrical hole 120 that traverses the one or more layers of the dielectric substrate 102 between the top and the bottom surfaces. The walls of the hole 120 are covered with a conductive material such that an electrical connection between the second region 116 of the antenna element 104 and the ground plate 108 is formed. The hole 120 may have a diameter d of 200 micrometers. However, the hole 120 may have any other suitable diameter d. The length I of the hole 120 is equal to the thickness of the dielectric substrate 102.

As shown in figs. 6 and 7, the antenna element 104 comprises an open loop shape. The second region 116 of the antenna element 104 which overlaps and connects to the conductive via 136 comprises an oval or drop shape. However, the second region may comprise any other suitable shape.

The open loop shape of the antenna element 104 comprises an oval shape. However, said shape may be chosen from the group consisting of rectangular, triangular, hexagonal and non-regular geometric shapes in other embodiments of the invention. The open loop shape may have a diameter between 100 micrometers and 5000 micrometers. Preferably the open loop shape may have a size between 500 micrometers and 1500 micrometers.

The dielectric substrate 102, the antenna element 104 and the ground plate 108 comprise an aperture 138 extending perpendicular to an antenna plane containing the antenna element 104 such that light can pass through the dielectric substrate 102, the antenna element 104 and the ground plate 108. The aperture 138 is surrounded by the open loop shape of the antenna element 104. In this way, laser light and NV fluorescence can pass through the aperture.

Furthermore, and as said, the feeding line 114 is tapered at the end closer to the loop shape for impedance matching. However, this is a non-limiting example and, in other embodiments of the invention, the feeding line 114 may not be tapered and/or the tapered section might have other suitable dimensions. As shown in figs. 2A-2B, 4 and 5, the microwave device 100 comprises a coaxial connector wherein the outside part of the coaxial connector is connected to the ground plate 108 and functions as a ground or negative terminal 132 for an input signal and a pin located inside and in the middle of the coaxial connector and going through the dielectric substrate 102 thereby connecting with the feeding line 114 functions as a signal terminal 134 for an input signal such that the input signal will be transmitted though the feeding line 114, the antenna element 104, and the conductive via 136 until reaching the ground plate 108 such that a magnetic field is generated at the open loop shape part of the antenna element 104.

The advantages of such a design are strength of the magnetic field, homogeneous frequency response as the microwave device is not resonant at a frequency of operation and the high current necessary to generate high-strength magnetic field is provided by the short-circuit created by the conductive via between the antenna element 104 and the ground plate 108, and spatial homogeneity because, within the loop shape, the generated magnetic field can be very homogeneous, which is important for NV sensing applications.

By using a shorted loop as described, high currents can be generated and therefore large magnetic fields. This is especially interesting for microwave devices for nitrogen-vacancy quantum sensing applications. In particular, this is useful for nitrogen-vacancy-based wide-field magnetometry, but it can also be used more broadly for microwave driving of other quantum defects, for example for characterization of individual defects.

In a further embodiment (not shown in the figures), the microwave device 100 may comprise one or more bottom extra layers of dielectric material formed on the ground plate. In this way, the microwave device 100 may comprise, from top to bottom, the antenna element 104, the dielectric substrate 102, the ground plate 108 and the one or more bottom layers of dielectric material.

In another embodiment, (also not shown in the figures), the microwave device 100 may comprise one or more top extra layers of dielectric material formed on the antenna element 104. In this way, the microwave device 100 may comprise, from top to bottom, the one or more top extra layers of dielectric material, the antenna element 104, the dielectric substrate 102, and the ground plate 108. This embodiment may be combined with the previous embodiment, such that the microwave device comprises the one or more top extra layers of dielectric material, the antenna element 104, the dielectric substrate 102, the ground plate 108 and the one or more bottom layers of dielectric material.

Fig. 8 shows a flowchart of a method of manufacturing a microwave device according to an embodiment of the disclosure. The method of manufacturing a microwave antenna of fig. 8 comprises a first step 802 wherein a dielectric substrate 102 comprising dielectric material is provided. After that, the method of fig. 8 proceeds to step 804 wherein a conductive via that extends through the dielectric substrate from a top surface of the dielectric substrate to a bottom surface of the substrate is formed, wherein the bottom surface is located opposite to the top surface.

After step 804, the method goes to step 806 which comprises forming an antenna element 104 on the top surface of the dielectric substrate 102. The method of fig. 8 proceeds then to step 808 which comprises forming a ground plate 108 on the bottom surface of the dielectric substrate 102 such that the antenna element 104 is electrically connected to the ground plate 108 via the conductive via.

Optionally, the method of fig. 8 may comprise a step of forming one or more bottom layers of dielectric material on the ground plate 108 and/or a step of forming one or more top layers of dielectric material on the antenna element 104.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

### LIST OF REFERENCE NUMBERS

microwave device: 100
dielectric substrate: 102
antenna element: 104
top surface of the dielectric substrate: 106
ground plate: 108
first region: 112
feeding line: 114
second region: 116
conductive via: 136
aperture: 138
ground terminal: 132
signal terminal: 134

## Claims

1. A microwave device (100) comprising:
- a dielectric substrate (102) comprising dielectric material and a conductive via (136) extending on the dielectric substrate between a top surface (106) of the dielectric substrate and a bottom surface of the dielectric substrate located opposite to the top surface (106);
- a ground plate (108) formed on the bottom surface and
- an antenna element (104) formed on the top surface (106) of the dielectric substrate, wherein the antenna element (104) comprises a first region (112) configured to receive an input signal and a second region (116) overlapping the conductive via (136) such that the antenna element (104) is electrically connected to the ground plate (108) at the second region (116) through the conductive via (136).

2. The microwave device (100) according to claim 1, wherein an ohmic resistance between the second region (116) of the antenna element (104) and the ground plate (108) is substantially zero.

3. The microwave device (100) according to any of the preceding claims, wherein the antenna element (104) comprises an open loop shape.

4. The microwave device (100) according to claim 3, wherein the second region (116) comprises an oval or drop shape.

5. The microwave device (100) according to any of claims 3-4 wherein the open loop shape is chosen from the group consisting of oval, rectangular, triangular, hexagonal and non-regular geometric shapes.

6. The microwave device (100) according to any of claims 3-5, wherein the open loop shape comprises a size between 10 micrometers and 10000 micrometers.

7. The microwave device (100) according to any of the previous claims, further comprising an aperture (138) extending from the top surface to the bottom surface such that light can pass through the dielectric substrate (102).

8. The microwave device (100) according to claim 7, wherein the aperture is surrounded by the open loop shape.

9. The microwave device (100) according to any of the preceding claims, wherein the microwave device is a printed circuit board.

10. The microwave device (100) according to any of the previous claims, further comprising one or more bottom extra layers of dielectric material formed on the ground plate (108) such that the microwave device (100) comprises, from top to bottom, the antenna element (104), the dielectric substrate (102), the ground plate (108) and the one or more bottom layers of dielectric material.

11. The microwave device (100) according to any of the previous claims, further comprising one or more top extra layers of dielectric material formed on the antenna element (104) such that the microwave device (100) comprises, from top to bottom, the one or more top extra layers of dielectric material, the antenna element (104), the dielectric substrate (102), and the ground plate (108).

12. A wide-field magnetometer for spatially mapping a magnetic field of a sample, the wide-field magnetometer comprising a diamond substrate comprising a plurality of nitrogen vacancy centers sensitive to the magnetic field of the sample, a light source configured to excite the plurality of nitrogen vacancy centers, and the microwave device (100) according to any of the previous claims, wherein the microwave device is configured to generate a first signal for the nitrogen vacancy centers such that an effect of the magnetic field of the sample on the plurality of vacancy centers can be measured to reconstruct the magnetic field of the sample.

13. A method for spatially mapping a magnetic field of a sample using the wide-field magnetometer of claim 12.

14. A method of manufacturing a microwave device, the method comprising:
- Providing (802) a dielectric substrate (102) comprising dielectric material;
- Forming (804) a conductive via (136) that extends through the dielectric substrate (102) from a top surface (106) of the dielectric substrate to a bottom surface of the substrate (102), wherein the bottom surface is located opposite to the top surface (106);
- Forming (806) an antenna element (104) on the top surface (106) of the substrate; and
- Forming (808) a ground plane structure (108) on the bottom surface of the dielectric substrate (102) such that the antenna element is electrically connected to the ground plate via the conductive via.
